(19)

**Europäisches Patentamt**
**European Patent Office**
**Office européen des brevets**

(11) **EP 3 962 008 B1**

(12) **EUROPEAN PATENT SPECIFICATION**

(45) Date of publication and mention
of the grant of the patent:
**16.10.2024   Bulletin 2024/42**

(51) International Patent Classification (IPC):
**H04B 1/04** *(2006.01)*      **H03F 3/24** *(2006.01)*
**H04L 25/03** *(2006.01)*

(21) Application number: **20814250.5**

(22) Date of filing: **28.05.2020**

(52) Cooperative Patent Classification (CPC):
**H04B 1/0475; H03F 1/3247; H03F 3/189;**
**H03F 3/24;** H03F 2200/451; H04B 2001/0425;
H04L 25/03343; H04L 27/368

(86) International application number:
**PCT/CN2020/093040**

(87) International publication number:
**WO 2020/239043 (03.12.2020 Gazette 2020/49)**

(54) **SIGNAL PROCESSING METHOD AND APPARATUS, AND STORAGE MEDIUM**

VERFAHREN UND VORRICHTUNG ZUR SIGNALVERARBEITUNG UND SPEICHERMEDIUM

PROCÉDÉ ET APPAREIL DE TRAITEMENT DE SIGNAL, ET SUPPORT DE STOCKAGE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority:   **28.05.2019   CN 201910450101**

(43) Date of publication of application:
**02.03.2022   Bulletin 2022/09**

(73) Proprietor: **ZTE Corporation**
**Shenzhen Guangdong  518057 (CN)**

(72) Inventors:
 • **DENG, Senyang**
   **Shenzhen, Guangdong 518057 (CN)**
 • **ZHANG, Zuofeng**
   **Shenzhen, Guangdong 518057 (CN)**
 • **DAI, Zhengjian**
   **Shenzhen, Guangdong 518057 (CN)**
 • **WANG, Lei**
   **Shenzhen, Guangdong 518057 (CN)**

(74) Representative: **Studio Torta S.p.A.**
**Via Viotti, 9**
**10121 Torino (IT)**

(56) References cited:
**CN-A- 102 412 855      CN-A- 102 763 389**
**CN-A- 102 763 389      CN-U- 208 675 192**
**US-A1- 2005 168 283    US-A1- 2012 321 018**
**US-A1- 2012 321 018    US-A1- 2017 303 118**

## Description

## TECHNICAL FIELD

Embodiments of the present disclosure relate to, but are not limited to, the field of signal processing, such as a signal processing method and device, and a storage medium.

## BACKGROUND

The non-linear characteristics of a power amplifier in a wireless communication system are strongly related to factors such as a power, a temperature, a bandwidth, etc. Therefore, a digital pre-distortion (DPD) system is required to extract characteristics of the power amplifier in real time, and to compensate for extracted characteristics of the power amplifier to ensure an undistorted output of the power amplifier. However, the wireless communication system often works in dynamic source scenarios, that is, service signals often change suddenly, which may cause sudden changes in power amplifier characteristics. In a process of the sudden changes, digital distortion characteristics and actual power amplifier characteristics may not adapt to each other, which affects a stability of the system. The compensation effect of the digital predistortion technology in related technologies strongly depends on characteristics of the service signal in an actual system, and it is difficult to compensate for abrupt power amplifier characteristics. Therefore, the technology of sending a sequence signal in an idle time slot has emerged. The characteristics of the sequence signal power and bandwidth are predetermined and included the power amplifier characteristics. The DPD compensation effect may be corrected under abrupt service signal characteristics.

There are also more and more running state detection technologies for communication equipment, such as a voltage standing wave ratio (VSWR) detection, a power detection, and a channel performance detection (such as adjacent channel leakage ratio (ACPR)), etc.. When it is detected that the VSWR is too large, the antenna port power is abnormal or the channel performance is deteriorated during a running process of the system, the system may make corresponding adjustments and release alarms in a timely manner, thereby improving system stability and facilitating system maintenance and troubleshooting. But in reality, these detection technologies in the system have a limited collection of signal sample points and are strongly dependent on the characteristics of the service signal. When the service signal undergoes a sudden change, false alarms may be released.

The service signal in a 5G new radio access technology (NR) system has a larger bandwidth, and the scheduling is more flexible and changeable, resulting in frequent changes in the power, frequency, bandwidth and other characteristics of the service signal. DPD technology and detection technology in related technologies face following problems.

(1) Since a state of the power amplifier varies with an external environment, a service signal power and the bandwidth, and also data sample points of an extracted DPD model are limited and are unable to reflect the signal characteristics of the entire data stream, the DPD compensation effect and the accuracy of related detection technologies are strongly dependent on the service signal characteristics, such that system stability and performance problems are more likely to happen.

(2) The technology of sending an auxiliary sequence signal in the idle time slot has great limitations: i) Some operators require that signals may not be sent in idle time slot; ii) Considering system networking performance, signals would not be sent in the idle time slot; iii) Not all signal systems have the idle time slot.

The related technology sends a specified signal in the idle time slot to correct the DPD model, but there are great limitations.

Patent application US 2005/0168283 A1 discloses that a transmission signal containing signals of a plurality of frequency bands is divided and fed to a linear signal transfer path including a delay circuit and a plurality of distortion generation paths for the plurality of frequency bands. In each distortion generation path, the signal of the corresponding frequency band is extracted by a band signal extractor from the signal fed to the path, an odd-order distortion of the extracted signal is generated by an odd-order distortion generator, and the phase and amplitude of the odd-order distortion are adjusted by a vector adjuster to provide the output signal of the distortion generation path. The output signals from such plurality of distortion generation paths are combined by a combiner with the output from the linear signal transfer path to provide the combined output as the output from a multi-band predistorter using power series representation.

Patent CN102763389B discloses a signal sequence processing method and a base station. The method includes: obtaining a signal sequence; forming a training signal with set signal attributes in the obtained signal sequence; performing pre-distortion processing on the signal sequence formed with the training signal by a pre-distortion model; amplifying and outputting the pre-distortion processed signal by the power amplifier module; collecting the amplified training signal in the signal sequence amplified and output by the power amplifier module; and correcting the pre-distortion model according to the collected training signal. The present disclosure enables the signal attribute of the training signal to be actively controlled by forming a training signal that meets the set requirements, and the above solution adapts to the feedback requirement for the correction of the pre-distortion model, so that the non-linearity of the training signal after passing through the power amplifier can be collected timely and effectively to modify the pre-distortion mode, and then the matching between the pre-distortion model and the power amplifier module can be optimized.

Patent application US 2012/0321018 A1 discloses a for digital pre-distortion processing method and apparatus, the method including that: training signals are sent to at least one radio frequency front-end device as needed (201); the output training signals of the radio frequency front-end devices are collected through a feedback channel as needed (202); digital pre-distortion (DPD) coefficients of the radio frequency front-end devices are trained as needed (203); after the coefficient training is completed, the DPD coefficients of the corresponding radio frequency front-end devices are updated as needed. There is no need to track the variation of the signals all the time and to compare the signals with a long-time statistical signal template to trigger the training in the invention. The invention can accommodate a multi-antennas application without configuring a corresponding digital pre-distortion feedback channel and coefficient training module separately for each antenna, thereby when the antennas are increased, the volume and cost are not increased and the invention can be of good feasibility from the perspective of commercialization.

## SUMMARY

The present invention relates to a signal processing method and device, as defined in the annexed claims, which can overcome a limitation of sending a designated signal in an idle time slot, realize a signal processing, and improve stability and performance of a system.

Some embodiments of the present disclosure provide a signal processing method, including:

generating a first training signal, adjusting a power of the first training signal, and adding a first training signal with an adjusted power to a first service signal to obtain a first combined signal; and
collecting a second combined signal output by a power amplifier or reflected by a post-stage circuit, extracting a second training signal from the second combined signal, and performing a signal processing based on the second training signal.

Some embodiments of the present disclosure provide a signal processing device, including:

a signal sending module, configured to generate a first training signal, adjust a power of the first training signal, and add a first training signal with a adjusted power to a first service signal to obtain a first combined signal;
a signal acquisition module, configured to collect a second combined signal output by a power amplifier or reflected by a post-stage circuit; and

a signal processing module, configured to extract a second training signal from the second combined signal, and perform a signal processing based on the second training signal.

Some embodiments of the present disclosure provide a signal processing device, including a processor and a computer-readable storage medium. The computer-readable storage medium stores an instruction that, when executed by the processor, allows the processor to perform any one of the signal processing methods.

Some embodiments of the present disclosure provide a computer-readable storage medium storing a computer program that, when executed by a processor, allows the processor to perform any one of the signal processing methods.

## BRIEF DESCRIPTION OF THE DRAWINGS

The accompanying drawings are used to facilitate an understanding of the technical solutions of the embodiments of the present disclosure, and constitute a part of the specification. Together with the embodiments of the present disclosure, the accompanying drawings are used to illustrate the technical solutions of the embodiments of the present disclosure, and do not constitute a limitation for the technical solutions of the embodiments of the present disclosure.

FIG. 1 is a flowchart of a signal processing method according to an embodiment of the present disclosure.
FIG. 2 is a schematic diagram of a method for extracting a second training signal from a second combined signal according to an embodiment of the present disclosure.
FIG. 3 is a flowchart of a signal processing method according to another embodiment of the present disclosure.
FIG. 4 is a flowchart of a signal processing method according to another embodiment of the present disclosure.
FIG. 5 is a schematic diagram of a structural composition of a signal processing device according to another embodiment of the present disclosure.
FIG. 6 is a first schematic diagram of a signal processing device according to an embodiment of the present disclosure.
FIG. 7 is a second schematic diagram of a signal processing device according to an embodiment of the present disclosure.
FIG. 8 is a schematic diagram of a TD-LTE frame structure according to an embodiment of the present disclosure.

## DETAILED DESCRIPTION

Embodiments of the present disclosure will be described with reference to the accompanying drawings below.

The steps shown in the flowcharts of the accompanying drawings may be executed in a computer system such as a set of computer-executable instructions. And, although a logical order is shown in the flowchart, in some cases, the steps shown or described may be performed in a different order than that described herein.

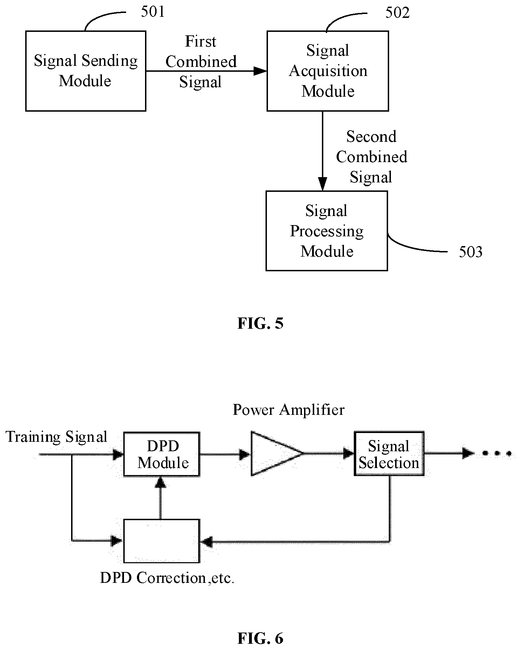

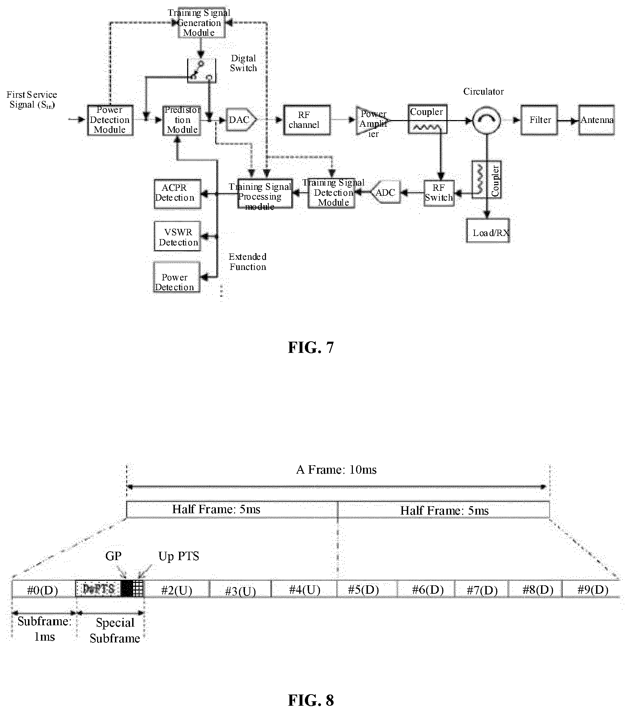

Before illustrating signal processing methods of the embodiments of the present disclosure, a processing procedure before sending a service signal is first described. As shown in FIG. 6 and FIG. 7, for a system without a digital predistortion model correction, after processed by processing modules such as a rate conversion module, a shaping filtering module, a peak clipping module, etc., baseband signals are converted into analog signals through a digital-to-analog converter (DAC) module, then enter a RF module to mix the analog signals into radio frequencies for a preliminary amplification, and enter a power amplifier module (i.e., power amplifier) for a power amplification, and finally pass through a filter and an antenna to convert the radio frequency signals into electromagnetic waves to emit.

Corresponding to a system after the digital predistortion model correction, the baseband signals are processed by the processing modules such as the rate conversion module, the shaping filtering module, the peak clipping module, etc., then enter a predistortion module for a digital predistortion processing. The signals after the digital predistortion processing is converted into the analog signals through the DAC module, and enter the radio frequency module to mix the analog signals to the radio frequencies for the preliminary amplification, then enter the power amplifier module (i.e., power amplifier) for the power amplification, and finally passes through the filter and the antenna to convert the radio frequencies into electromagnetic waves to emit.

The signals after the power amplification are collected, distortion characteristics are extracted based on the signals after the power amplification and the signals before the power amplification, and the digital predistortion model is corrected based on the distortion characteristics.

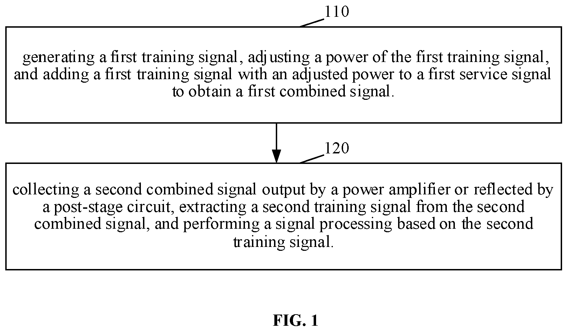

Referring to FIG. 1, an embodiment of the present disclosure provides a signal processing method, including following steps.

In step 110, generating a first training signal Ts, adjusting a power of the first training signal Ts, and adding a first training signal Ts with an adjusted power to a first service signal Sin to obtain a first combined signal Sout.

In the embodiment of the present disclosure, the first service signal Sin includes any one of the following: a baseband service signal, a service signal before a digital predistortion processing, and a service signal after the digital predistortion processing.

In other words, the first training signal Ts with the adjusted power may be added to the baseband service signal; or the first training signal Ts with the adjusted power may also be added to the service signal before the digital predistortion processing; or, the first training signal Ts may also be added to the service signal after the digital predistortion processing.

In the embodiment of the present disclosure, generating the first training signal Ts includes: selecting a training signal with a bandwidth equal to a bandwidth corresponding to high and low frequency points of a filter in hardware configuration information from pre-stored training signals with different bandwidths; processing a selected training signal based on the hardware configuration information to obtain the first training signal Ts.

In the embodiment of the present disclosure, the bandwidths of the pre-stored training signals with different bandwidths are between a minimum bandwidth and a maximum bandwidth required by the system, and a power of the pre-stored training signals is a rated power configured by the system (that is, a carrier power of each carrier in the hardware configuration information), a peak-to-average ratio of the pre-stored training signals is a maximum peak-to-average ratio required by the system under the rated power.

In the embodiment of the present disclosure, the hardware configuration information includes: the number of the carriers, the carrier power of each of the carriers, a carrier bandwidth of each of the carriers, a frequency of a numerically controlled oscillator (NCO), a local oscillator, and the high and low frequency points of the filter.

The selected training signal is copied and frequency shifted based on the number of the carriers, so that a frequency corresponding to each of the carrier has a corresponding training signal, and a bandwidth of the training signal corresponding to each of the carriers is determined by the carrier bandwidth of the carrier in the hardware configuration information. A center frequency point of the first training signal Ts is determined by the local oscillator and the NCO frequency in the hardware configuration information, the NCO frequency is an offset of the local oscillator, and the total bandwidth of the first training signal is determined by the bandwidth corresponding to the high and low frequency points of the filter.

In the embodiment of the present disclosure, adjusting the power of the first training signal Ts includes: adjusting the power of the first training signal Ts to be less than an average power of the first service signal Sin.

The average power of the first service signal Sin is calculated based on a formula

$$Pow(n) = \frac{1}{N} \sum_{i=n-N+1}^{n} \left| S_{in}(i) \right|^2$$

.

Herein, n is a sampling sequence number of a signal window corresponding to the first service signal Sin, N is a window length of the signal window, and $S_{in}$

(*i*) is an i-th first service signal value in the signal window.

When the power is adjusted, an adjustment ratio may be calculated based on a current power of the first training signal and an average power of the first service signal, that is, the adjustment ratio is a ratio of the average power of the first service signal to the current power of the first training signal. Then the first training signal with the adjusted power may be obtained by multiplying the current power of the first training signal by the adjustment ratio.

In the embodiment of the present disclosure, adding the first training signal Ts with the adjusted power to the first service signal Sin to obtain the first combined signal Sout includes: determining a maximum average power of average powers of the first service signal Sin in all the signal windows within a first preset time and a peak power of a signal window corresponding to the maximum average power. Herein a length of the signal window is greater than or equal to a length of the first training signal Ts, and adding the first training signal Ts with the adjusted power to a signal window meeting a preset condition in the first service signal Sin to obtain the first combined signal Sout. Herein the preset condition includes: the average power of the first service signal Sin in the signal window is greater than or equal to a product of the maximum average power and β, and the peak power of the first service signal Sin in the signal window is greater than or equal to a product of the peak value of the signal window corresponding to the maximum average power and β. β is a power adjustment factor which may be a preset value.

In another embodiment of the present disclosure, in a case that β is greater than a preset threshold, and a signal window meeting a preset condition is unable to be found for M consecutive times in the first service signal Sin, the method further includes: reducing β, and continuing to add the first training signal Ts with the adjusted power to the signal window meeting the preset condition in the first service signal Sin to obtain the first combined signal Sout, herein M is an integer greater than or equal to 1.

In another embodiment of the present disclosure, when β is less than or equal to the preset threshold, and the signal window meeting the preset condition is unable to be found for M consecutive times in the first service signal Sin, the method further includes: continuing to determine a maximum average power of average powers of the first service signal Sin in all signal windows within a second preset time and a peak power of a signal window corresponding to the maximum average power, herein M is an integer greater than or equal to 1.

In the embodiment of the present disclosure, the following method may be used to determine the maximum average power of the average power of the first service signal Sin in all the signal windows within the first preset time or the second preset time and the peak power of the signal window corresponding to the maximum average power: counting the average powers and the peak power of the first service signal Sin in all the signal windows in the first preset time or the second preset time; determining the maximum average power and the peak power of the signal window corresponding to the maximum average power based on the average powers and the peak power of the first service signal Sin in all the signal windows.

The average powers of the first service signal Sin in the signal window are calculated based on a formula

$$Pow(n) = \frac{1}{N} \sum_{i=n-N+1}^{n} |S_{in}(i)|^2$$

, herein n is the sampling sequence number of the signal window corresponding to the first service signal Sin, N is the window length of the signal window, and $S_{in}(i)$ is an i-th service signal value in the signal window. Herein, the maximum average power is a maximum value of the average powers of the first service signal Sin in all the signal windows.

In the embodiment of the present disclosure, the first training signal with the adjusted power may be added to the first service signal based on a certain weight or a specified orthogonal manner to ensure that a demodulation of the service signal is not affected.

In step 120, collecting a second combined signal Yout output by a power amplifier or reflected by a post-stage circuit, extracting a second training signal Ts_out from the second combined signal, and performing a signal processing based on the second training signal Ts_out.

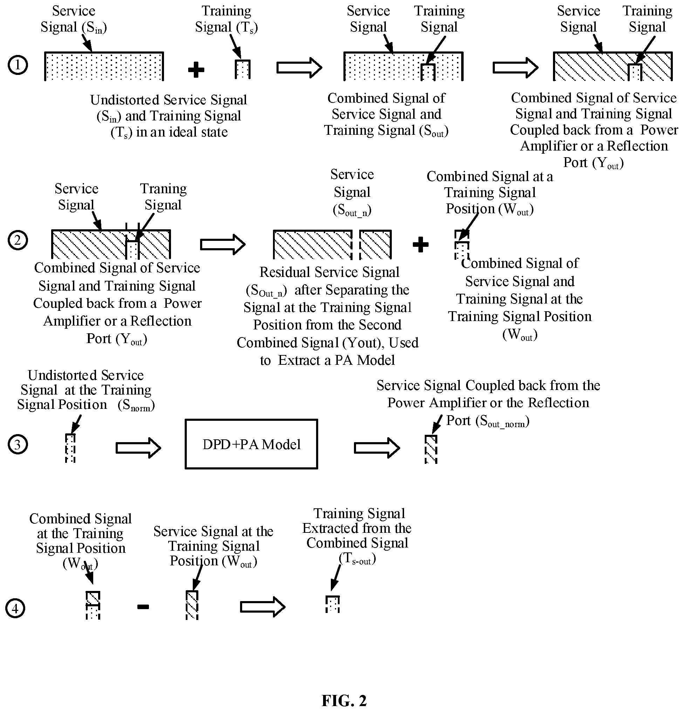

In the embodiment of the present disclosure, as shown in FIG. 2, extracting the second training signal Ts_out from the second combined signal Yout includes: separating the second combined signal Yout into a second service signal Sout_n that does not include the second training signal and a third combined signal Wout that includes the second training signal, which may be achieved by controlling a link data collection delay in a case of separation; extracting a predetermined model based on the first service signal Sin and the second service signal Sout_n; herein the predetermined model includes a power amplifier model, or a digital predistortion model and the power amplifier model; calculating a third service signal Sout_norm in the third combined signal Wout based on the first service signal Sin and the predetermined model; calculating the second training signal Ts_out in the third combined signal Wout based on the third combined signal Wout and the third service signal Sout_norm; herein the second training signal Ts_out is a difference between the third combined signal Wout and the third service signal Sout_norm.

The following is divided into three cases to illustrate an extraction process of each case.

(1) When the first service signal Sin is the baseband service signal, the extraction process may be performed by any one of the following modes.

Mode 1

The second combined signal Yout is separated into the second service signal Sout_n that does not include the second training signal and the third combined signal Wout that includes the second training signal, which may be achieved by controlling the link data collection delay in as case of separation.

The first service signal Sin is converted into a fourth service signal before the digital predistortion processing. In an embodiment, the first service signal is subjected to processing, such as the rate conversion, the shaping filtering, the peak clipping, etc., to obtain the fourth service signal before the digital predistortion processing.

The digital predistortion model and the power amplifier model are extracted based on a part of the fourth service signal corresponding to the second service signal Sout_n and the second service signal Sout_n.

The third service signal Sout_norm is calculated based on a part of Snorm in the fourth service signal corresponding to the third combined signal Wout, the digital predistortion model and the power amplifier model.

The second training signal Ts_out in the third combined signal Wout is calculated based on the third combined signal Wout and the third service signal Sout_norm. In an embodiment, the second training signal Ts_out is the difference between the third combined signal Wout and the third service the signal Sout_norm.

Mode 2

The second combined signal Yout is separated into the second service signal Sout_n that does not include the second training signal and the third combined signal Wout that includes the second training signal, which may be achieved by controlling the link data collection delay in a case of separation.

The first service signal Sin is converted into a fifth service signal after the digital predistortion processing. In an embodiment, the first service signal is subjected to the processing, such as the rate conversion, the shaping filtering, the peak clipping, and the digital predistortion processing, to obtain the fifth service signal after the digital predistortion processing.

The power amplifier model is extracted based on a part of the fifth service signal corresponding to the second service signal and the second service signal.

The third service signal Sout_norm is calculated based on a part of Snorm in the fifth service signal corresponding to the third combined signal Wout and the power amplifier model.

The second training signal Ts_out in the third combined signal Wout is calculated based on the third combined signal Wout and the third service signal Sout_norm. In an embodiment, the second training signal Ts_out is the difference between the third combined signal Wout and the third service the signal Sout_norm.

(2) In a case that the first service signal Sin is the service signal before the predistortion processing, the extraction process may be performed by any one of the following modes.

Mode 1

The second combined signal Yout is separated into the second service signal Sout_n that does not include the second training signal and the third combined signal Wout that includes the second training signal, which may be achieved by controlling the link data collection delay in a case of separation.

The digital predistortion model and the power amplifier model are extracted based on a part of the first service signal Sin corresponding to the second service signal Sout_n and the second service signal Sout_n.

The third service signal Sout_norm is calculated based on a part of Snorm corresponding to the third combined signal Wout in the first service signal Sin, the digital predistortion model and the power amplifier model.

The second training signal Ts_out in the third combined signal Wout is calculated based on the third combined signal Wout and the third service signal Sout_norm. In an embodiment, the second training signal Ts_out is the difference between the third combined signal Wout and the third service the signal Sout_norm.

Mode 2

The second combined signal Yout is separated into the second service signal Sout_n that does not include the second training signal and the third combined signal Wout that includes the second training signal, which may be achieved by controlling the link data collection delay in a case of separation.

The first service signal Sin is converted into the fifth service signal after the digital predistortion processing.

The power amplifier model is extracted based on a part of the fifth service signal corresponding to the second service signal Sout_n and the second service signal Sout_n.

The third service signal Sout_norm is calculated based on a part of Snorm in the fifth service signal corresponding to the third combined signal Wout and the power amplifier model.

The second training signal Ts_out in the third combined signal Wout is calculated based on the third combined signal Wout and the third service signal Sout_norm. In an embodiment, the second training signal Ts_out is the difference between the third combined signal Wout and the third service the signal Sout_norm.

(3) In a case that the first service signal Sin is the service signal after the predistortion processing, the extraction process may be performed by the following modes.

The second combined signal Yout is separated into the second service signal Sout_n that does not include the second training signal and the third combined signal Wout that includes the second training signal, which may be achieved by controlling the link data collection delay in a case of separation.

The power amplifier model is extracted based on a part of the first service signal Sin corresponding to the second service signal Sout_n and the second service signal Sout_n.

The third service signal Sout_norm is calculated based on a part of Snorm in the first service signal Sin corresponding to the third combined signal Wout and the power amplifier model.

The second training signal Ts_out in the third combined signal Wout is calculated based on the third combined signal Wout and the third service signal Sout_norm. In an embodiment, the second training signal Ts_out is the difference between the third combined signal Wout and the third service the signal Sout_norm.

In the embodiment of the present disclosure, the signal processing includes at least one of correcting the digital predistortion (DPD) model and performing a running state detection.

In an embodiment, the running state detection includes at least one of a voltage standing wave ratio (VSWR) detection, a power detection, a channel performance detection (for example, an adjacent channel protection ratio (ACPR) performance) and other technologies.

In the embodiment of the present disclosure, in a case that the first service signal Sin is the baseband service signal or the service signal before the digital predistortion processing, before performing the signal processing based on the second training signal Ts_out, the method further includes: converting the first training signal Ts with the adjusted power into a fourth training signal after the digital predistortion processing. And performing the signal processing based on the second training signal Ts_out includes: performing the signal processing based on the second training signal Ts_out and the fourth training signal. For example, distortion characteristics are acquired based on the second training signal Ts_out and the fourth training signal, and the DPD model is corrected based on the distortion characteristics.

When the first training signal Ts with the adjusted power is added to the baseband service signal, the first training signal Ts with the adjusted power needs to be subjected to the processing, such as the rate conversion, the shaping filtering, the peak clipping, and the digital predistortion processing, to obtain the fourth training signal.

When the first training signal Ts with the adjusted power is added to the service signal before the digital predistortion processing, the first training signal Ts with the adjusted power needs to be subjected to the digital predistortion processing to obtain the fourth training signal.

In the embodiment of the present disclosure, when the first service signal Sin is the service signal after the digital predistortion processing, performing the signal processing based on the second training signal Ts_out includes: performing the signal processing based on the second training signal Ts_out and the first training signal Ts with the adjusted power. For example, the distortion characteristics are obtained based on the second training signal Ts_out and the first training signal Ts with the adjusted power, and the DPD model is corrected based on the distortion characteristics.

The embodiment of the present disclosure adds the training signal to the service signal to perform the signal processing (for example, a DPD model correction, a running state detection, etc.), which overcomes a limitation of sending designated signals in an idle time slot, thereby improving a stability and a performance of the system.

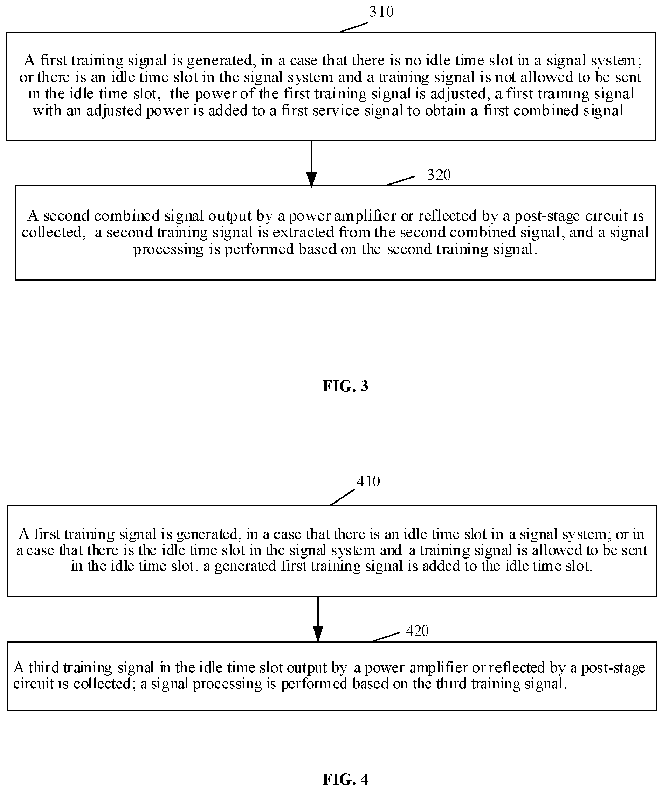

Referring to FIG. 3, another embodiment of the present disclosure provides a signal processing method, including the following steps.

In step 310, a first training signal is generated, in a case that there is no idle time slot in a signal system; or, in a case that there is an idle time slot in the signal system, and a training signal is not allowed to be sent in the idle time slot, a power of the first training signal is adjusted, a first training signal with an adjusted power is added to a first service signal to obtain a first combined signal.

In this step, the implementation process of generating the first training signal, adjusting the power of the first training signal, and adding the first training signal with the adjusted power to the first service signal to obtain the first combined signal is the same as that of step 110 in a previous embodiment, and will not be repeated here.

In step 320, a second combined signal output by a power amplifier or reflected by a post-stage circuit is collected, a second training signal is extracted from the second combined signal, and a signal processing is performed based on the second training signal.

The implementation process of step 320 is the same as that of step 120 in the previous embodiment, and will not be repeated here.

In another embodiment of the present disclosure, in a case that there is the idle time slot in the signal system, or in a case that there is the idle time slot in the signal system and the training signal is allowed to be sent in the idle time slot, the method further includes: adding a generated first training signal to the idle time slot; collecting a third training signal in the idle time slot output by the power amplifier or reflected by the post-stage circuit; performing the signal processing based on the third training signal. The implementation process is the same as that of step 410 and step 420 in a following embodiment, and will not be repeated here.

Referring to FIG. 4, another embodiment of the present disclosure provides a signal processing method, including the following steps.

In step 410, a first training signal is generated, in a case that there is an idle time slot in a signal system; or in a case that there is the idle time slot in the signal system and a training signal is allowed to be sent in the idle time slot, a generated first training signal is added to the idle time slot.

In this step, the implementation process of generating the first training signal is the same as that of generating the first training signal in step 110 of the previous embodiment, and will not be repeated here.

When the first training signal is added to the idle time slot, there is no need to adjust a power of the generated first training signal which may be directly added to the idle time slot.

For example, FIG. 8 is a frame structure diagram of a time division long term evolution (TD-LTE) based on an embodiment of the present disclosure. One frame is 10ms, including two half frames, with a total of 10 subframes, each of which is 1ms. A 0th subframe is a downlink subframe, and a 1st subframe is a special subframe. There is a GP (idle time slot) position in the special subframe. 2nd, 3rd, and 4th subframes are uplink subframes, and 5-9th subframes are downlink subframes. Then, the first training signal may be sent in the idle time slot GP or in subframes of downlink service signals.

In step 420, a third training signal in the idle time slot output by a power amplifier or reflected by a post-stage circuit is collected; a signal processing is performed based on the third training signal.

In the embodiment of the present disclosure, the signal processing includes at least one of correcting a digital predistortion (DPD) model and performing a running state detection.

The running status detection includes at least one of the following: a VSWR detection, a power detection, a channel performance detection (such as ACPR performance) and other technologies.

In the embodiment of the present disclosure, in a case that a first service signal Sin is a baseband service signal or a service signal before the digital predistortion processing, before performing the signal processing based on the third training signal, the method further includes: converting a first training signal with an adjusted power Ts into a fourth training signal after the digital predistortion processing. And performing the signal processing based on the third training signal includes performing the signal processing based on the third training signal and the fourth training signal. For example, distortion characteristics are acquired based on the third training signal and the fourth training signal, and the DPD model is corrected based on the distortion characteristics.

In a case that the first training signal Ts with the adjusted power is added to the baseband service signal, the first training signal Ts with the adjusted power needs to be subjected to processing, such as a rate conversion, a shaping filtering, a peak clipping, and the digital predistortion processing etc., to obtain the fourth training signal. In a case that the first training signal Ts with the adjusted power is added to the service signal before the digital predistortion processing, the first training signal Ts with the adjusted power needs to be subjected to the digital predistortion processing to obtain the fourth training signal.

In the embodiment of the present disclosure, in a case that the first service signal Sin is the service signal after the digital predistortion processing, performing the signal processing based on the third training signal includes: performing the signal processing based on the third training signal and the first training signal Ts. For example, the distortion characteristics are acquired based on the third training signal and the first training signal Ts, and the DPD model is corrected based on the distortion characteristics.

In the embodiment of the present disclosure, the training signal is added to the idle time slot to perform the signal processing only when there is the idle time slot in the signal system, or when there is the idle time slot in the signal system and the training signal is allowed to be sent in the idle time slot, which overcomes a limitation of sending designated signals in the idle time slot, thereby improving the stability and performance of the system.

In other words, the embodiment of the present disclosure may send the training signal in any position of a data stream (including idle time slots and service signals). The power and bandwidth of the training signal are fixed, so that the traning singal has a wider bandwidth characteristics, which may make the training signal have richer power amplifier distortion characteristics or reflection characteristics, thereby improving the stability and performance of the DPD model correction and running state detection technology, suitable for all signal standard systems, such as a time division duplexing (TDD) and a frequency division duplexing (FDD).

In addition, the signal processing method of the embodiment of the present disclosure is highly scalable, including the DPD model correction, a voltage standing wave ratio detection, the power detection, and a ACPR detection, etc., which can greatly reduce a degree of coupling with the service signals and improve an overall stability and performance indicators of a communication system.

Referring to FIG. 5, another embodiment of the present disclosure provides a signal processing device, including: a signal sending module 501, configured to generate a first training signal, adjust a power of the first training signal, and add a first training signal with a adjusted power to a first service signal to obtain a first combined signal; a signal acquisition module 502, configured to collect a second combined signal output by a power amplifier or reflected by a post-stage circuit; a signal processing module 503, configured to extract a second training signal from the second combined signal, and perform a signal processing based on the second training signal.

In another embodiment of the present disclosure, the signal sending module 501 is further configured to, generate the first training signal, in a case that there is no idle time slot in a signal system; or, in a case that there is an idle time slot in the signal system and a training signal is not allowed to be sent in the idle time slot, add the first training signal with the adjusted power to the first service signal to obtain the first combined signal.

In another embodiment of the present disclosure, the signal sending module 501 is further configured to add a generated first training signal to the idle time slot, in a case that there is the idle time slot in the signal system; or in a case that there is the idle time slot in the signal system and the training signal is allowed to be sent in the idle time slot. The signal acquisition module 502 is also configured to collect a third training signal in the idle time slot output by the power amplifier or reflected by the post-stage circuit. The signal processing module 503 is also configured to perform the signal processing based on the third training signal.

In the embodiment of the present disclosure, the signal sending module 501 is configured to adjust the power of the first training signal in the following manner: adjusting the power of the first training signal to be less than an average power of the first service signal.

In the embodiment of the present disclosure, the signal sending module 501 is configured to generate the first training signal in the following manner: selecting a training signal with a bandwidth equal to a bandwidth corresponding to high and low frequency points of a filter in hardware configuration information from pre-stored training signals with different bandwidths; and processing a selected training signal based on the hardware configuration information to obtain the first training signal.

In the embodiment of the present disclosure, the signal sending module 501 is configured to add the first training signal with the adjusted power to the first service signal to obtain the first combined signal in the following manner: determining a maximum average power of the first service signal in all signal windows within a first preset time and a peak power of a signal window corresponding to the maximum average power; herein a length of the signal window is greater than or equal to a length of the first training signal; adding the first training signal with the adjusted power to a signal window meeting a preset condition in the first service signal to obtain the first combined signal. Herein, the preset condition includes: an average power of the first service signal in the signal window is greater than or equal to a product of the maximum average power and $\beta$, and the peak power of the first service signal in the signal window is greater than or equal to a product of the peak value of the signal window corresponding to the maximum average power and $\beta$.

In the embodiment of the present disclosure, the signal sending module 501 is further configured to: reduce $\beta$ in a case that $\beta$ is greater than a preset threshold and the signal window meeting the preset condition is unable to be found for M consecutive times in the first service signal, and continue to add the first training signal with the adjusted power to the signal window meeting the preset condition in the first service signal to obtain the first combined signal; herein M is an integer greater than or equal to 1.

In the embodiment of the present disclosure, the signal sending module 501 is further configured to continue to determine a maximum average power of the first service signal in all the signal windows within a second preset time and a peak power of a signal window corresponding to the maximum average power, in a case that $\beta$ is less than or equal to the preset threshold and the signal window meeting the preset condition in the first service signal is unable to be found for M consecutive times, herein M is an integer greater than or equal to 1.

In the embodiment of the present disclosure, the first service signal includes any one of the following: a baseband service signal, a service signal before a digital predistortion processing, and a service signal after the digital predistortion processing.

In the embodiment of the present disclosure, the signal processing module 503 is further configured to: extract the second training signal from the second combined signal, convert the first training signal with the adjusted power into a fourth training signal after the digital predistortion processing in a case that the first service signal is the baseband service signal or the service signal before the digital predistortion processing, perform the signal processing based on the second training signal and the fourth training signal.

In the embodiment of the present disclosure, the signal processing module 503 is configured to extract the second training signal from the second combined signal, and perform the signal processing based on the second training signal and the first training signal with the adjusted power in a case that the first service signal is the baseband service signal.

In the embodiment of the present disclosure, the signal processing module 503 is configured to extract the second training signal from the second combined signal in the following manner: separating the second combined signal into a second service signal that does not include the second training signal and a third combined signal that includes the second training signal; extracting a predetermined model based on the first service signal and the second service signal; herein the predetermined model includes a power amplifier model, or a digital predistortion model and a power amplifier model; calculating a third service signal in the third combined signal based on the first service signal and the predetermined model; and calculating the second training signal in the third combined signal based on the third combined signal and the third service signal.

In the embodiment of the present disclosure, the signal processing module 503 is further configured to: convert the first service signal into a fourth service signal before the digital predistortion processing or a fifth service signal after the digital predistortion processing in a case that the first service signal is the baseband service signal or the service signal before the digital predistortion processing; extract the digital predistortion model and the power amplifier model based on a part of the fourth service signal corresponding to the second service signal and the second service signal; or, extract the power amplifier model from a part of the fifth service signal corresponding to the second service signal and the second service signal; calculate the third service signal based on a part of the fourth service signal corresponding to the third combined signal, the digital predistortion model and the power amplifier model; alternatively, calculate the third service signal based on a part of the fifth service signal corresponding to the third combined signal and the power amplifier model.

In the embodiment of the present disclosure, the signal processing module 503 is configured to: extract the digital predistortion model and the power amplifier model based on a part of the first service signal corresponding to the second service signal and the second service signal in a case that the first service signal is the service signal before the predistortion processing; calculate the third service signal based on a part of the first service signal corresponding to the third combined signal, the digital predistortion model and the power amplifier model.

In the embodiment of the present disclosure, the signal processing module 503 is configured to: extract the power amplifier model based on the part of the first service signal corresponding to the second service signal and the second service signal in a case that the first service signal is the service signal after the predistortion processing; calculate the third service signal based on the part of the first service signal corresponding to the third combined signal and the power amplifier model.

In the embodiment of the present disclosure, the signal processing includes at least one of correcting the digital predistortion model and performing a running state detection.

The implementation process of the above signal processing device is the same as that of the signal processing method in the foregoing embodiment, and will not be repeated here.

FIG. 6 is a schematic diagram of a signal processing device according to an embodiment of the present disclosure. As shown in FIG. 6, the signal processing device adds the training signal to the service signal, and outputs the service signal after passing through a predistortion module and a power amplifier. The training signal is extracted from a signal output by the power amplifier. At this time, the training signal contains power amplifier distortion characteristics. The signal processing device can help a system modify a digital pre-distortion model and improve stability and performance of the DPD in different service signal scenarios.

The signal processing device includes: a pre-distortion module, a power amplifier module (i.e., a power amplifier), a signal selection module, and a predistortion correcting module.

In an embodiment, the predistortion module is configured to correct a nonlinearity of the power amplifier to ensure a linear output of the power amplifier.

The power amplifier is configured to mainly amplify a power of a radio frequency signal, and finally make the radio frequency signal transmitted into a space in a form of electromagnetic waves through the filter and an antenna.

The signal selection module mainly includes a switch (optional, including a digital switch and/or a radio frequency switch), a circulator (optional) and a coupler. The circulator is configured to isolate transmitted signals and reflected signals, and use the coupler to couple part of the transmitted or reflected signals into an analog-to-digital converter (ADC) module for a collection. The system may set up and control the digital and radio frequency switches based on the specific requirements of each function, so as to ensure the normal and orderly operation of the entire system.

The pre-distortion correction module is configured to use a first training signal without distortion and a second training signal coupled back to the power amplifier port to extract the power amplifier distortion characteristics of the training signal for a pre-distortion model correction.

FIG. 7 is another schematic diagram of a signal processing device according to an embodiment of the present disclosure. As shown in FIG. 7, the signal processing device adds a training signal to a service signal, and then outputs the service signal after passing through a predistortion module and a power amplifier. The training signal is extracted from a signal output by the power amplifier or a signal reflected by a post-stage circuit. At this time, the training signal includes power amplifier distortion, reflection and other characteristics. The signal processing device can help a system: (1) modify a digital predistortion model to improve stability and performance of the DPD in different service signal scenarios; (2) improve stability of a standing wave ratio detection in the different service signal scenarios; (3) improve stability of a system power detection in multiple service scenarios; (4) perform an ACPR online detection, etc.

The signal processing device mainly includes eight modules: a training signal generation module, a training signal detection module, a training signal processing module, a power detection module, a predistortion module, a radio frequency module, a power amplifier module (i.e. power amplifier), a signal selection module, a digital to analog converter (DAC) module and an analog to digital converter (ADC) module.

The power detection module is configured to count an average power and a peak power of a current digital signal in real time, and send the average power and peak power of the current digital signal to the training signal generation module to determine relevant parameters of a first training signal, such as a power, a peak-to-average ratio, etc.

The training signal generating module is configured to generate a first training signal Ts, adjust a power of the first training signal Ts, and determine a position that a first training signal Ts with an adjusted power added to a first service signal Sin.

The predistortion module is configured to correct a nonlinearity of the power amplifier to ensure a linear output of the power amplifier.

The DAC module is configured to convert digital signals into analog signals.

The ADC module is configured to convert analog signals into digital signals.

The radio frequency module is configured to perform a spectrum shifting and a small signal amplification for the analog signals.

The power amplifier is configured to mainly amplify a power of a radio frequency signal, and finally make the radio frequency signal transmitted into a space in a form of electromagnetic waves through an filter and an antenna (that is, the post-stage circuit).

The signal selection module mainly includes a switch (optional, including a digital switch and/or a radio frequency switch), a circulator (optional) and a coupler. The circulator is configured to isolate transmitted signals and reflected signals, and uses the coupler to couple part of the transmitted signals and reflected signals into the ADC module for collection. The system may set up and control the digital and radio frequency switches based on the specific requirements of each function, so as to ensure the normal and orderly operation of the entire system.

The training signal detection module is configured to, in a case that the first training signal is added to the first service signal for sending, establish a service signal power amplifier model based on characteristics of the first training signal sent in advance and the first service signal at a position of the first training signal, and extract a second training signal from a coupling signal of a power amplifier output port or a reflection port.

The training signal processing module is configured to use a distortion-free first training signal and the second training signal coupled back to the power amplifier port or the reflection port to extract power amplifier distortion characteristics or reflection characteristics of the training signal, and set them as pre-distortion model correction and standing wave ratio calculation correction, respectively.

Another embodiment of the present disclosure provides a signal processing device including a processor and a computer-readable storage medium. The computer-readable storage medium stores an instruction that, when executed by the processor, allows the processor to perform anyone of the signal processing methods.

Another embodiment of the present disclosure provides a computer-readable storage medium storing a computer program that, when executed by a processor, allows the processor to perform the steps of anyone of the signal processing methods.

A person of ordinary skill in the art may understand that all or some of the steps, system, functional modules/units of the device in the methods disclosed above may be implemented as software, firmware, hardware, and appropriate combinations thereof. In a hardware implementation, the division between functional modules/units mentioned in the above description does not necessarily correspond to the division of physical components. For example, a physical component may have multiple functions, or a function or step may be performed by several physical components cooperatively. Some or all of the components may be implemented as software executed by a processor (such as a digital signal processor or a microprocessor), or as hardware, or as an integrated circuit (such as an application specific integrated circuit). Such software may be distributed on a computer-readable medium, and the computer-readable medium may include a computer storage medium (or a non-transitory medium) and a communication medium (or a transitory medium). As is well known to those of ordinary skill in the art, the term computer storage medium includes volatile and non-volatile, removable and non-removable medium implemented in any method or technology for storing information (such as computer-readable instructions, data structures, program modules, or other data). Computer storage medium include but are not limited to a random access memory (RAM), a read-only memory (ROM), an electrically erasable programmable read-only memory (EEPROM), a flash memory or other memory technologies, a compact disc read-only memory (CD-ROM), a digital video disc (DVD) or other optical disk storage, a magnetic cassette, a magnetic tape, a magnetic disk storage or other magnetic storage devices, or any other medium used to store desired information and that may be accessed by a computer. In addition, as well known to those of ordinary skill in the art, communication medium usually contain a computer-readable instruction, a data structure, a program module, or other data in a modulated data signal such as a carrier wave or other transmission mechanisms, and may include any information delivery medium.

**Claims**

1. A signal processing method, comprising:

generating a first training signal, adjusting a power of the first training signal, and adding a first training signal with an adjusted power to a first service signal to obtain a first combined signal; and
collecting a second combined signal output by a power amplifier or reflected by a post-stage circuit to which the first combined signal is input, extracting a second training signal from the second combined signal, and performing a signal processing based on the second training signal, the signal processing comprising correcting a digital predistortion DPD model, **characterized in that**: extracting the second training signal from the second combined signal comprises:

> separating the second combined signal into a second service signal that does not include the second training signal and a third combined signal that includes the second training signal; extracting a predetermined model based on the first service signal and the second service signal; wherein the predetermined model comprises a power amplifier model, or a digital predistortion model and the power amplifier model; calculating a third service signal in the third combined signal based on the first service signal and the predetermined model; and calculating the second training signal in the third combined signal based on the third combined signal and the third service signal.

2. The method according to claim 1, further comprising:

> in response to there being no idle time slot in a signal system; or in response to there being an idle time slot in the signal system and a training signal being not allowed to be sent in the idle time slot, continuing to adjust the power of the first training signal; and wherein adjusting the power of the first training signal comprises adjusting the power of the first training signal to be less than an average power of the first service signal.

3. The method according to claim 1, in response to there being an idle time slot in a signal system; or in response to there being an idle time slot in the signal system and a training signal being allowed to be sent in the idle time slot, the method further comprises:

> adding the first training signal generated to the idle time slot; collecting a third training signal in the idle time slot output by the power amplifier or reflected by the post-stage circuit; and performing the signal processing based on the third training signal; and wherein generating the first training signal comprises:

>> selecting a training signal with a bandwidth equal to a bandwidth corresponding to a high and low frequency point of a filter in hardware configuration information from pre-stored training signals of different bandwidths; processing a selected training signal based on the hardware configuration information to obtain the first training signal.

4. The method according to claim 1, wherein adding the first training signal with the adjusted power to the first service signal to obtain the first combined signal comprises:

> determining a maximum average power of average powers of the first service signal in all signal windows within a first preset time and a peak power of a signal window corresponding to the maximum average power; wherein a length of the signal window is greater than or equal to a length of the first training signal; adding the first training signal with the adjusted power to a signal window meeting a preset condition in the first service signal to obtain the first combined signal; wherein the preset condition comprises:

>> the average power of the first service signal in the signal window is greater than or equal to a product of the maximum average power and $\beta$, and the peak power of the first service signal in the signal window is greater than or equal to a product of the peak value of the signal window corresponding to the maximum average power and $\beta$.

5. The method according to claim 4, when $\beta$ is greater than a preset threshold and the signal window meeting the preset condition in the first service signal is unable to be found for M consecutive times, the method further comprises:

> reducing $\beta$ and continuing to add the first training signal with the adjusted power to the signal window meeting the preset condition in the first service signal to obtain the first combined signal; wherein M is an integer greater than or equal to 1; or when $\beta$ is less than or equal to a preset threshold, and the signal window meeting the preset condition in the first service signal is unable to be found for M consecutive times, the method further comprises:

>> continuing to determine a maximum average power of average powers of the first service signal in all signal windows within a second preset time and a peak power of a signal window corresponding to the maximum average power;
wherein M is an integer greater than or equal to 1.

6. The method according to claim 1, wherein the first service signal comprises any one of a baseband service signal, a service signal before a digital predistortion processing, and a service signal after the digital predistortion processing; and
the signal processing further comprises performing a running state detection.

7. The method according to claim 6, when the first service signal is the baseband service signal or the service signal before the digital predistortion processing, before performing the signal processing based on the second training signal, the method further comprises:

converting the first training signal with the adjusted power into a fourth training signal after the digital predistortion processing; and
performing the signal processing based on the second training signal comprises:
performing the signal processing based on the second training signal and the fourth training signal.

8. The method according to claim 6, wherein when the first service signal is a baseband service signal, performing the signal processing based on the second training signal comprises:
performing the signal processing based on the second training signal and the first training signal with the adjusted power.

9. The method according to claim 1, when the first service signal is a baseband service signal or a service signal before a digital predistortion processing, before extracting the predetermined model based on the first service signal and the second service signal, the method further comprises:

converting the first service signal into a fourth service signal before the digital predistortion processing or a fifth service signal after the digital predistortion processing; and
extracting the predetermined model based on the first service signal and the second service signal comprises:

extracting the digital predistortion model and the power amplifier model based on a part of the fourth service signal corresponding to the second service signal and the second service signal; or,

extracting the power amplifier model based on a part of the fifth service signal corresponding to the second service signal and the second service signal; and

calculating the third service signal in the third combined signal based on the first service signal and a predetermined model comprises:

calculating the third service signal based on a part of the fourth service signal corresponding to the third combined signal, the digital predistortion model and the power amplifier model; or
calculating the third service signal based on a part of the fifth service signal corresponding to the third combined signal and the power amplifier model.

10. The method according to claim 1, wherein when the first service signal is a service signal before a predistortion processing, extracting the predetermined model according to the first service signal and the second service signal comprises:

extracting the digital predistortion model and the power amplifier model based on a part of the first service signal corresponding to the second service signal and the second service signal; and
calculating the third service signal in the third combined signal based on the first service signal and the predetermined model comprises:
calculating the third service signal based on a part of the first service signal corresponding to the third combined signal, the digital predistortion model and the power amplifier model.

11. The method according to claim 1, wherein when the first service signal is a service signal after a predistortion processing, extracting the predetermined model based on the first service signal and the second service signal comprises:

extracting the power amplifier model based on a part of the first service signal corresponding to the second service signal and the second service signal; and
calculating the third service signal in the third combined signal based on the first service signal and the predetermined model comprises:
calculating the third service signal based on a part of the first service signal corresponding to the third combined signal and the power amplifier model.

12. A signal processing device, comprising:

a signal sending module, configured to generate a first training signal, adjust a power of the first training signal, and add a first training signal with a adjusted power to a first service signal to obtain a first combined signal;

a signal acquisition module, configured to collect a second combined signal output by a power amplifier or reflected by a post-stage circuit to which the first combined signal is input; and

a signal processing module, configured to extract a second training signal from the second combined signal, and perform a signal processing based on the second training signal, the signal processing comprising correcting a digital predistortion DPD model, **characterized in that**:

the signal processing module is further configured to:

extract the second training signal from the second combined signal comprises:

separate the second combined signal into a second service signal that does not include the second training signal and a third combined signal that includes the second training signal;

extract a predetermined model based on the first service signal and the second service signal;

wherein the predetermined model comprises a power amplifier model, or a digital predistortion model and the power amplifier model;

calculate a third service signal in the third combined signal based on the first service signal and the predetermined model; and

calculate the second training signal in the third combined signal based on the third combined signal and the third service signal.

13. A signal processing device, comprising a processor and a computer-readable storage medium, wherein the computer-readable storage medium stores an instruction that, when executed by the processor, causes the processor to perform the signal processing method according to any one of claims 1-11.

14. A computer-readable storage medium storing a computer program that, when executed by a processor, causes the processor to perform the signal processing method according to any one of claims 1-11.

**Patentansprüche**

1. Signalverarbeitungsverfahren, umfassend:

Erzeugen eines ersten Trainingssignals, Anpassen einer Leistung des ersten Trainingssignals und Hinzufügen eines ersten Trainingssignals mit einer angepassten Leistung zu einem ersten Dienstsignal, um ein erstes kombiniertes Signal zu erhalten; und

Sammeln eines zweiten kombinierten Signals, das von einem Leistungsverstärker ausgegeben oder von einer Nachstufenschaltung reflektiert wird, in die das erste kombinierte Signal eingegeben wird, Extrahieren eines zweiten Trainingssignals aus dem zweiten kombinierten Signal und Durchführen einer Signalverarbeitung basierend auf dem zweiten Trainingssignal, wobei die Signalverarbeitung das Korrigieren eines digitalen Vorverzerrungs-DPD-Modells umfasst, **dadurch gekennzeichnet, dass:**

das Extrahieren des zweiten Trainingssignals aus dem zweiten kombinierten Signal umfasst:

Auftrennen des zweiten kombinierten Signals in ein zweites Dienstsignal, das das zweite Trainingssignal nicht einschließt, und ein drittes kombiniertes Signal, das das zweite Trainingssignal einschließt;

Extrahieren eines vorbestimmten Modells basierend auf dem ersten Dienstsignal und dem zweiten Dienstsignal; wobei das vorbestimmte Modell ein Leistungsverstärkermodell oder ein digitales Vorverzerrungsmodell und das Leistungsverstärkermodell umfasst;

Berechnen eines dritten Dienstsignals im dritten kombinierten Signal basierend auf dem ersten Dienstsignal und dem vorbestimmten Modell; und

Berechnen des zweiten Trainingssignals im dritten kombinierten Signal basierend auf dem dritten kombinierten Signal und dem dritten Dienstsignal.

2. Verfahren nach Anspruch 1, ferner umfassend:

als Reaktion darauf, dass in einem Signalsystem kein freier Zeitschlitz vorhanden ist; oder als Reaktion darauf, dass im Signalsystem ein freier Zeitschlitz vorhanden ist und in dem freien Zeitschlitz kein Trainingssignal gesendet werden darf, Fortsetzen der Anpassung der Leistung des ersten Trainingssignals; und wobei das Anpassen der Leistung des ersten Trainingssignals das Anpassen der Leistung des ersten Trainingssignals derart umfasst, dass sie geringer ist als eine durchschnittliche Leistung des ersten Dienstsignals.

3. Verfahren nach Anspruch 1 als Reaktion auf das Vorhandensein eines freien Zeitschlitzes in einem Signalsystem; oder

als Reaktion darauf, dass ein freier Zeitschlitz im Signalsystem vorhanden ist und das Senden eines Trainingssignals in dem freien Zeitschlitz zulässig ist, das Verfahren ferner umfasst:

Hinzufügen des ersten generierten Trainingssignals zum freien Zeitschlitz;
Sammeln eines dritten Trainingssignals im freien Zeitschlitz, das vom Leistungsverstärker ausgegeben oder von der Nachstufenschaltung reflektiert wird; und
Durchführen der Signalverarbeitung basierend auf dem dritten Trainingssignal; und
wobei das Generieren des ersten Trainingssignals umfasst:

Auswählen eines Trainingssignals mit einer Bandbreite gleich einer Bandbreite, die einem Hoch- und Niederfrequenzpunkt eines Filters in den Hardwarekonfigurationsinformationen aus vorab gespeicherten Trainingssignalen unterschiedlicher Bandbreiten entspricht;
Verarbeiten eines ausgewählten Trainingssignals basierend auf den Hardwarekonfigurationsinformationen, um das erste Trainingssignal zu erhalten.

4. Verfahren nach Anspruch 1, wobei das Hinzufügen des ersten Trainingssignals mit der angepassten Leistung zum ersten Dienstsignal zum Erhalten des ersten kombinierten Signals umfasst:

Bestimmen einer maximalen Durchschnittsleistung der Durchschnittsleistungen des ersten Dienstsignals in allen Signalfenstern innerhalb einer ersten voreingestellten Zeit und einer Spitzenleistung eines Signalfensters, die der maximalen Durchschnittsleistung entspricht; wobei eine Länge des Signalfensters größer als oder gleich einer Länge des ersten Trainingssignals ist;
Hinzufügen des ersten Trainingssignals mit der angepassten Leistung zu einem Signalfenster, das eine voreingestellte Bedingung im ersten Dienstsignal erfüllt, um das erste kombinierte Signal zu erhalten; wobei die voreingestellte Bedingung umfasst:

die durchschnittliche Leistung des ersten Dienstsignals im Signalfenster ist größer als oder gleich ein Produkt aus der maximalen durchschnittlichen Leistung und β und
die Spitzenleistung des ersten Dienstsignals im Signalfenster ist größer als oder gleich ein Produkt aus dem Spitzenwert des Signalfensters, das der maximalen Durchschnittsleistung entspricht, und β.

5. Verfahren nach Anspruch 4, wenn β größer als ein voreingestellter Schwellenwert ist und das Signalfenster, das die voreingestellte Bedingung im ersten Dienstsignal erfüllt, M-mal hintereinander nicht gefunden werden kann, wobei das Verfahren ferner umfasst:

Reduzieren von β und Fortsetzen des Hinzufügens des ersten Trainingssignals mit der angepassten Leistung zu dem Signalfenster, das die voreingestellte Bedingung im ersten Dienstsignal erfüllt, um das erste kombinierte Signal zu erhalten;
wobei M eine Ganzzahl größer als oder gleich 1 ist; oder
wenn β kleiner als oder gleich ein voreingestellter Schwellenwert ist und das Signalfenster, das die voreingestellte Bedingung im ersten Dienstsignal erfüllt, M-mal hintereinander nicht gefunden werden kann, das Verfahren ferner umfasst:

Fortsetzen des Bestimmens einer maximalen Durchschnittsleistung der Durchschnittsleistungen des ersten Dienstsignals in allen Signalfenstern innerhalb einer zweiten voreingestellten Zeit und einer Spitzenleistung eines Signalfensters, die der maximalen Durchschnittsleistung entspricht;
wobei M eine Ganzzahl größer als oder gleich 1 ist.

6. Verfahren nach Anspruch 1, wobei das erste Dienstsignal eines von einem Basisband-Dienstsignal, einem Dienstsignal vor einer digitalen Vorverzerrungsverarbeitung oder einem Dienstsignal nach der digitalen Vorverzerrungsverarbeitung umfasst; und die Signalverarbeitung ferner die Durchführung einer Laufzustandserkennung umfasst.

7. Verfahren nach Anspruch 6, wenn das erste Dienstsignal das Basisband-Dienstsignal oder das Dienstsignal vor der digitalen Vorverzerrungsverarbeitung ist, vor dem Durchführen der Signalverarbeitung basierend auf dem zweiten Trainingssignal das Verfahren ferner umfasst:

Umwandeln des ersten Trainingssignals mit der angepassten Leistung in ein viertes Trainingssignal nach der digitalen Vorverzerrungsverarbeitung; und
das Durchführen der Signalverarbeitung basierend auf dem zweiten Trainingssignal umfasst:
das Durchführen der Signalverarbeitung basierend auf dem zweiten Trainingssignal und dem vierten Trainingssignal.

**8.** Verfahren nach Anspruch 6, wobei, wenn das erste Dienstsignal ein Basisband-Dienstsignal ist, das Durchführen der Signalverarbeitung basierend auf dem zweiten Trainingssignal umfasst:
Durchführen der Signalverarbeitung basierend auf dem zweiten Trainingssignal und dem ersten Trainingssignal mit der angepassten Leistung.

**9.** Verfahren nach Anspruch 1, wenn das erste Dienstsignal ein Basisband-Dienstsignal oder ein Dienstsignal vor einer digitalen Vorverzerrungsverarbeitung ist, vor dem Extrahieren des vorbestimmten Modells basierend auf dem ersten Dienstsignal und dem zweiten Dienstsignal das Verfahren ferner umfasst:

Umwandeln des ersten Dienstsignals in ein viertes Dienstsignal vor der digitalen Vorverzerrungsverarbeitung oder in ein fünftes Dienstsignal nach der digitalen Vorverzerrungsverarbeitung; und
das Extrahieren eines vorbestimmten Modells basierend auf dem ersten Dienstsignal und dem zweiten Dienstsignal umfasst:

Extrahieren des digitalen Vorverzerrungsmodells und des Leistungsverstärkermodells basierend auf einem Teil des vierten Dienstsignals, der dem zweiten Dienstsignal und dem zweiten Dienstsignal entspricht; oder
Extrahieren des Leistungsverstärkermodells basierend auf einem Teil des fünften Dienstsignals, der dem zweiten Dienstsignal und dem zweiten Dienstsignal entspricht; und
das Berechnen des dritten Dienstsignals im dritten kombinierten Signal basierend auf dem ersten Dienstsignal und einem vorbestimmten Modell umfasst:

Berechnen des dritten Dienstsignals basierend auf einem Teil des vierten Dienstsignals, der dem dritten kombinierten Signal, dem digitalen Vorverzerrungsmodell und dem Leistungsverstärkermodell entspricht; oder
Berechnen des dritten Dienstsignals basierend auf einem Teil des fünften Dienstsignals, der dem dritten kombinierten Signal und dem Leistungsverstärkermodell entspricht.

**10.** Verfahren nach Anspruch 1, wobei, wenn das erste Dienstsignal ein Dienstsignal vor einer Vorverzerrungsverarbeitung ist, das Extrahieren des vorbestimmten Modells gemäß dem ersten Dienstsignal und dem zweiten Dienstsignal umfasst:

Extrahieren des digitalen Vorverzerrungsmodells und des Leistungsverstärkermodells basierend auf einem Teil des ersten Dienstsignals, der dem zweiten Dienstsignal und dem zweiten Dienstsignal entspricht; das Berechnen des dritten Dienstsignals im dritten kombinierten Signal basierend auf dem ersten Dienstsignal und dem vorbestimmten Modell umfasst:
Berechnen des dritten Dienstsignals basierend auf einem Teil des ersten Dienstsignals, der dem dritten kombinierten Signal, dem digitalen Vorverzerrungsmodell und dem Leistungsverstärkermodell entspricht.

**11.** Verfahren nach Anspruch 1, wobei, wenn das erste Dienstsignal ein Dienstsignal nach einer Vorverzerrungsverarbeitung ist, das Extrahieren des vorbestimmten Modells basierend auf dem ersten Dienstsignal und dem zweiten Dienstsignal umfasst:

Extrahieren des Leistungsverstärkermodells basierend auf einem Teil des ersten Dienstsignals, der dem zweiten Dienstsignal und dem zweiten Dienstsignal entspricht; und
das Berechnen des dritten Dienstsignals im dritten kombinierten Signal basierend auf dem ersten Dienstsignal und dem vorbestimmten Modell umfasst:
Berechnen des dritten Dienstsignals basierend auf einem Teil des ersten Dienstsignals, der dem dritten kombinierten Signal und dem Leistungsverstärkermodell entspricht.

**12.** Signalverarbeitungsvorrichtung, umfassend:

ein Signalsendemodul, konfiguriert zum Erzeugen eines ersten Trainingssignals, Anpassen einer Leistung des ersten Trainingssignals und Hinzufügen eines ersten Trainingssignals mit einer angepassten Leistung zu einem ersten Dienstsignal, um ein erstes kombiniertes Signal zu erhalten;
ein Signalerfassungsmodul, konfiguriert zum Sammeln eines zweiten kombinierten Signals, das von einem Leistungsverstärker ausgegeben oder von einer Nachstufenschaltung reflektiert wird, in die das erste kombinierte Signal eingegeben wird; und
ein Signalverarbeitungsmodul, konfiguriert zum Extrahieren eines zweiten Trainingssignals aus dem zweiten kombinierten Signal und Durchführen einer Signalverarbeitung basierend auf dem zweiten Trainingssignal, wobei die Signalverarbeitung das Korrigieren eines digitalen Vorverzerrungs-DPD-Modells umfasst,
**dadurch gekennzeichnet, dass:**
das Signalverarbeitungsmodul ferner konfiguriert ist zum:

Extrahieren des zweiten Trainingssignals aus dem zweiten kombinierten Signal, das umfasst:

Auftrennen des zweiten kombinierten Signals in ein zweites Dienstsignal, das das zweite Trainingssignal nicht einschließt, und ein drittes kombiniertes Signal, das das zweite Trainingssignal einschließt;

Extrahieren eines vorbestimmten Modells basierend auf dem ersten Dienstsignal und dem zweiten Dienstsignal;

wobei das vorbestimmte Modell ein Leistungsverstärkermodell oder ein digitales Vorverzerrungsmodell und das Leistungsverstärkermodell umfasst;

Berechnen eines dritten Dienstsignals im dritten kombinierten Signal basierend auf dem ersten Dienstsignal und dem vorbestimmten Modell; und

Berechnen des zweiten Trainingssignals im dritten kombinierten Signal basierend auf dem dritten kombinierten Signal und dem dritten Dienstsignal.

13. Signalverarbeitungsvorrichtung, umfassend einen Prozessor und ein computerlesbares Speicherungsmedium umfasst, wobei das computerlesbare Speicherungsmedium eine Anweisung speichert, die, wenn sie durch den Prozessor ausgeführt werden, bewirken,

dass der Prozessor das Signalverarbeitungsverfahren nach einem der Ansprüche 1 bis 11 durchführt.

14. Computerlesbares Speicherungsmedium, auf dem ein Computerprogramm gespeichert ist, das, wenn es durch einen Prozessor ausgeführt wird, den Prozessor veranlasst zum

Durchführen des Signalverarbeitungsverfahrens nach einem der Ansprüche 1 bis 11.

## Revendications

1. Procédé de traitement de signal, comprenant :

la génération d'un premier signal d'entraînement, l'ajustement de la puissance du premier signal d'entraînement, et l'ajout d'un premier signal d'entraînement avec une puissance ajustée à un premier signal de service pour obtenir un premier signal combiné ; et

la collecte d'un deuxième signal combiné émis par un amplificateur de puissance ou réfléchi par un circuit de post-activation dans lequel le premier signal combiné est entré, l'extraction d'un deuxième signal d'entraînement du deuxième signal combiné, et la réalisation d'un traitement de signal basé sur le deuxième signal d'entraînement, le traitement de signal comprenant la correction d'un modèle de pré-distorsion numérique, DPD, **caractérisé en ce que** :
l'extraction du deuxième signal d'entraînement du deuxième signal combiné comprend :

la séparation du deuxième signal combiné en un deuxième signal de service qui ne comporte pas le deuxième signal d'entraînement et un troisième signal combiné qui comporte le deuxième signal d'entraînement ;

l'extraction d'un modèle prédéterminé sur la base du premier signal de service et du deuxième signal de service ; dans lequel le modèle prédéterminé comprend un modèle d'amplificateur de puissance, ou un modèle de pré-distorsion numérique et le modèle d'amplificateur de puissance ;

le calcul d'un troisième signal de service dans le troisième signal combiné sur la base du premier signal de service et du modèle prédéterminé ; et

le calcul du deuxième signal d'entraînement dans le troisième signal combiné sur la base du troisième signal combiné et du troisième signal de service.

2. Procédé selon la revendication 1, comprenant en outre :

en réponse à l'absence d'intervalle temporel inactif dans un système de signaux ; ou en réponse à l'existence d'un intervalle temporel inactif dans le système de signal et à l'interdiction d'envoyer un signal d'entraînement dans l'intervalle temporel inactif, la poursuite de l'ajustement de la puissance du premier signal d'entraînement ; et

dans lequel l'ajustement de la puissance du premier signal d'entraînement comprend l'ajustement de la puissance du premier signal d'entraînement de sorte qu'elle soit inférieure à une puissance moyenne du premier signal de service.

3. Procédé selon la revendication 1, en réponse à l'existence d'un intervalle temporel inactif dans un système de signaux ; ou
en réponse à l'existence d'un intervalle temporel inactif dans le système de signaux et à l'autorisation d'envoyer un signal d'entraînement dans l'intervalle temporel inactif, le procédé comprend en outre :

l'ajout du premier signal d'entraînement généré à l'intervalle temporel inactif ;

la collecte d'un troisième signal d'entraînement dans l'intervalle temporel inactif émis par l'amplificateur de puissance ou réfléchi par le circuit de post-activation ; et

la réalisation du traitement de signal sur la base du troisième signal d'entraînement ; et

dans lequel la génération du premier signal d'entraînement comprend :

la sélection d'un signal d'entraînement avec une largeur de bande égale à une largeur de bande correspondant à un point de haute et de basse fréquence d'un filtre dans des informations de configuration matérielle à partir de signaux d'entraînement pré-stockés de différentes largeurs de bande ;

le traitement d'un signal d'entraînement sélectionné sur la base des informations de configuration matérielle afin d'obtenir le premier signal d'entraînement.

4. Procédé selon la revendication 1, dans lequel l'ajout du premier signal d'entraînement avec la puissance ajustée au premier signal de service pour obtenir le premier signal combiné comprend :

la détermination d'une puissance moyenne maximale de puissances moyennes du premier signal de service dans toutes les fenêtres de signal au cours d'une première période prédéfinie et une puissance de crête d'une fenêtre de signal correspondant à la puissance moyenne maximale ; dans lequel une longueur de la fenêtre de signal est supérieure ou égale à une longueur du premier signal d'entraînement ;

l'ajout du premier signal d'entraînement avec la puissance ajustée à une fenêtre de signal satisfaisant à une condition prédéfinie dans le premier signal de service afin d'obtenir le premier signal combiné ; dans lequel la condition prédéfinie comprend :

la puissance moyenne du premier signal de service dans la fenêtre de signal étant supérieure ou égale à un produit de la puissance moyenne maximale et de $\beta$, et

la puissance de crête du premier signal de service dans la fenêtre de signal est supérieure ou égale au produit de la valeur de crête de la fenêtre de signal correspondant à la puissance moyenne maximale et de $\beta$.

5. Procédé selon la revendication 4, lorsque $\beta$ est supérieur à un seuil prédéfini et que la fenêtre de signal satisfaisant à la condition prédéfinie dans le premier signal de service ne peut pas être trouvée pendant M fois consécutives, le procédé comprend en outre :

la réduction de $\beta$ et la poursuite de l'ajout du premier signal d'entraînement avec la puissance ajustée à la fenêtre de signal satisfaisant à la condition prédéfinie dans le premier signal de service pour obtenir le premier signal combiné ; dans lequel M est un nombre entier supérieur ou égal à 1 ; ou

lorsque $\beta$ est inférieur ou égal à un seuil prédéfini, et que la fenêtre de signal satisfaisant à la condition prédéfinie dans le premier signal de service ne peut pas être trouvée pendant M fois consécutives, le procédé comprend en outre :

la poursuite de la détermination d'une puissance moyenne maximale de puissances moyennes du premier signal de service dans toutes les fenêtres de signal au cours d'une seconde période prédéfinie et une puissance de crête d'une fenêtre de signal correspondant à la puissance moyenne maximale ;

dans lequel M est un nombre entier supérieur ou égal à 1.

6. Procédé selon la revendication 1, dans lequel le premier signal de service comprend l'un quelconque parmi un signal de service en bande de base, un signal de service avant un traitement de pré-distorsion numérique, et un signal de service après le traitement de pré-distorsion numérique ; et

le traitement de signal comprend en outre la réalisation d'une détection de l'état de marche.

7. Procédé selon la revendication 6, lorsque le premier signal de service est le signal de service en bande de base ou le signal de service avant le traitement de pré-distorsion numérique, avant de réaliser le traitement de signal sur la base du deuxième signal d'entraînement, le procédé comprend en outre :

la conversion du premier signal d'entraînement avec la puissance ajustée en un quatrième signal d'entraînement après le traitement de pré-distorsion numérique ; et

la réalisation du traitement de signal sur la base du deuxième signal d'entraînement comprend : la réalisation du traitement de signal sur la base du deuxième signal d'entraînement et du quatrième signal d'entraînement.

8. Procédé selon la revendication 6, dans lequel, lorsque le premier signal de service est un signal de service en bande de base, la réalisation du traitement de signal sur la base du deuxième signal d'entraînement comprend :

la réalisation du traitement de signal sur la base du deuxième signal d'entraînement et du premier signal d'entraînement avec la puissance ajustée.

9. Procédé selon la revendication 1, lorsque le premier signal de service est un signal de service en bande de base ou un signal de service avant un traitement de pré-distorsion numérique, avant l'extraction du modèle prédéterminé sur la base du premier signal de service et du deuxième signal de service, le procédé comprend en outre :

la conversion du premier signal de service en un quatrième signal de service avant le traitement de pré-distorsion numérique ou en un cinquième signal de service après le traitement de pré-distorsion numérique ; et l'extraction du modèle prédéterminé sur la base du premier signal de service et du deuxième signal de service comprend :

l'extraction du modèle de pré-distorsion numérique et du modèle d'amplificateur de puissance sur la base d'une partie du quatrième signal de service correspondant au deuxième signal de service et du deuxième signal de service ; ou,
l'extraction du modèle d'amplificateur de puissance sur la base d'une partie du cinquième signal de service correspondant au deuxième signal de service et du deuxième signal de service ; et le calcul du troisième signal de service dans le troisième signal combiné sur la base du premier signal de service et d'un modèle prédéterminé comprend :

le calcul du troisième signal de service sur la base d'une partie du quatrième signal de service correspondant au troisième signal combiné, au modèle de pré-distorsion numérique et au modèle d'amplificateur de puissance ; ou le calcul du troisième signal de service sur la base d'une partie du cinquième signal de service correspondant au troisième signal combiné et au modèle d'amplificateur de puissance.

10. Procédé selon la revendication 1, dans lequel, lorsque le premier signal de service est un signal de service avant un traitement de pré-distorsion, l'extraction du modèle prédéterminé selon le premier signal de service et le deuxième signal de service comprend :

l'extraction du modèle de pré-distorsion numérique et du modèle d'amplificateur de puissance sur la base d'une partie du premier signal de service correspondant au deuxième signal de service et du deuxième signal de service ; et le calcul du troisième signal de service dans le troisième signal combiné sur la base du premier signal de service et du modèle prédéterminé comprend :
le calcul du troisième signal de service sur la base d'une partie du premier signal de service correspondant au troisième signal combiné, au modèle de pré-distorsion numérique et au modèle d'amplificateur de puissance.

11. Procédé selon la revendication 1, dans lequel, lorsque le premier signal de service est un signal de service après un traitement de pré-distorsion, l'extraction du modèle prédéterminé sur la base du premier signal de service et du deuxième signal de service comprend :

l'extraction du modèle d'amplificateur de puissance sur la base d'une partie du premier signal de service correspondant au deuxième signal de service et du deuxième signal de service ; et le calcul du troisième signal de service dans le troisième signal combiné sur la base du premier signal de service et du modèle prédéterminé comprend :
le calcul du troisième signal de service sur la base d'une partie du premier signal de service correspondant au troisième signal combiné et au modèle d'amplificateur de puissance.

12. Dispositif de traitement de signal, comprenant :

un module d'envoi de signal, configuré pour générer un premier signal d'entraînement, ajuster une puissance du premier signal d'entraînement, et ajouter un premier signal d'entraînement avec une puissance ajustée à un premier signal de service pour obtenir un premier signal combiné ;
un module d'acquisition de signal, configuré pour collecter un deuxième signal combiné émis par un amplificateur de puissance ou réfléchi par un circuit de post-activation dans lequel le premier signal combiné est entré ; et
un module de traitement de signal, configuré pour extraire un deuxième signal d'entraînement du deuxième signal combiné, et réaliser un traitement de signal sur la base du deuxième signal d'entraînement, le traitement de signal comprenant la correction d'un modèle de pré-distorsion numérique, DPD,
**caractérisé en ce que** :
le module de traitement de signal est en outre configuré pour :
extraire le deuxième signal d'entraînement du deuxième signal combiné comprenant :

la séparation du deuxième signal combiné en un deuxième signal de service qui ne comporte pas le deuxième signal d'entraînement et un troisième signal combiné qui comporte le deuxième signal d'entraînement ;

l'extraction d'un modèle prédéterminé sur la base du premier signal de service et du deuxième signal de service ;

dans lequel le modèle prédéterminé comprend un modèle d'amplificateur de puissance, ou un modèle de pré-distorsion numérique et le modèle d'amplificateur de puissance ;

le calcul d'un troisième signal de service dans le troisième signal combiné sur la base du premier signal de service et du modèle prédéterminé ; et

le calcul du deuxième signal d'entraînement dans le troisième signal combiné sur la base du troisième signal combiné et du troisième signal de service.

13. Dispositif de traitement de signal comprenant un processeur et un support de stockage lisible par ordinateur, dans lequel le support de stockage lisible par ordinateur stocke une instruction qui, lorsqu'elle est exécutée par le processeur, amène
le processeur à réaliser le procédé de traitement de signal selon l'une quelconque des revendications 1 à 11.

14. Support de stockage lisible par ordinateur stockant un programme informatique qui, lorsqu'il est exécuté par un processeur, amène le processeur
à réaliser le procédé de traitement de signal selon l'une quelconque des revendications 1 à 11.

110

generating a first training signal, adjusting a power of the first training signal, and adding a first training signal with an adjusted power to a first service signal to obtain a first combined signal.

120

collecting a second combined signal output by a power amplifier or reflected by a post-stage circuit, extracting a second training signal from the second combined signal, and performing a signal processing based on the second training signal.

**FIG. 1**

**FIG. 2**

310

A first training signal is generated, in a case that there is no idle time slot in a signal system; or there is an idle time slot in the signal system and a training signal is not allowed to be sent in the idle time slot, the power of the first training signal is adjusted, a first training signal with an adjusted power is added to a first service signal to obtain a first combined signal.

320

A second combined signal output by a power amplifier or reflected by a post-stage circuit is collected, a second training signal is extracted from the second combined signal, and a signal processing is performed based on the second training signal.

**FIG. 3**

410

A first training signal is generated, in a case that there is an idle time slot in a signal system; or in a case that there is the idle time slot in the signal system and a training signal is allowed to be sent in the idle time slot, a generated first training signal is added to the idle time slot.

420

A third training signal in the idle time slot output by a power amplifier or reflected by a post-stage circuit is collected; a signal processing is performed based on the third training signal.

**FIG. 4**

501

502

Signal Sending Module

First Combined Signal

Signal Acquisition Module

Second Combined Signal

Signal Processing Module

503

**FIG. 5**

Power Amplifier

Training Signal

DPD Module

Signal Selection

· · ·

DPD Correction,etc.

**FIG. 6**

**FIG. 7**

**FIG. 8**

**EP 3 962 008 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050168283 A1
- CN 102763389 B
- US 20120321018 A1